(19) **Europäisches Patentamt European Patent Office Office européen des brevets**

(11) **EP 2 594 111 B1**

(12) **EUROPEAN PATENT SPECIFICATION**

(45) Date of publication and mention of the grant of the patent:
**28.10.2015 Bulletin 2015/44**

(51) Int Cl.:
***H05B 6/76*** (2006.01)

(21) Application number: **11782469.8**

(22) Date of filing: **14.07.2011**

(86) International application number:
**PCT/IB2011/002328**

(87) International publication number:
**WO 2012/007842 (19.01.2012 Gazette 2012/03)**

(54) **A CHOKE FOR AN OVEN**

DROSSEL FÜR EINEN OFEN

PIÈGE DESTINÉ À UN FOUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.08.2010 US 377269 P**
**15.07.2010 US 364707 P**

(43) Date of publication of application:
**22.05.2013 Bulletin 2013/21**

(73) Proprietor: **Goji Limited**
**Hamilton HM08 (BM)**

(72) Inventors:
• **EINZIGER, Pinchas**
**34655 Haifa (IL)**
• **RAPPEL, Amit**
**90627 Ofra (IL)**
• **BIBERMAN, Yoel**
**35435 Haifa (IL)**
• **SIGALOV, Michael**
**84786 Beer-Sheva (IL)**
• **DIKAROV, Denis**
**44643 Kfar Saba (IL)**
• **IBRAGIMOV, Zalman**
**76470 Rehovot (IL)**
• **JAKIRA, Yuval**
**62098 Tel Aviv (IL)**

(74) Representative: **Miller, James Lionel Woolverton et al**
**Kilburn & Strode LLP**
**20 Red Lion Street**
**London WC1R 4PJ (GB)**

(56) References cited:
| EP-A2- 1 744 596 | EP-A2- 1 744 597 |
| WO-A1-00/36878 | GB-A- 1 392 498 |
| GB-A- 2 011 770 | JP-A- 2003 243 150 |
| US-A- 3 767 884 | US-A- 4 137 441 |

## Description

<u>Priority</u>

This application claims the benefit of priority of U.S. Provisional Application No. 61/364,707, filed July 15, 2010 entitled "CHOKE FOR AN OVEN," and U.S. Provisional Application No. 61/377,269, filed August 26, 2010 entitled "CHOKE FOR AN OVEN".

<u>Technical Field</u>

This application relates to apparatuses for blocking or reducing electromagnetic energy leakage from an interface between a door and an oven cavity.

## Background

Electromagnetic (EM) energy leakage issues are main concerns in many electromagnetic applications. In designing ovens or oven cavities that utilize electromagnetic radiation, potential leakage needs to be dealt such that the energy is maintained within the oven cavity. Radio Frequency (RF) chokes are used in order to attenuate electromagnetic leakage from the oven cavity. A choke may take the form of a groove or other shape in the surface of a waveguide having a configuration adapted to attenuate RF waves within a given frequency range and maintain the cavity boundary conditions. Some examples of chokes include: mechanical chokes designed to attenuate the RF waves using $\lambda/4$ structures or dielectric chokes using dielectric material with high losses to attenuate the RF waves.

EP 1744597 and EP 1744596 disclose a microwave cooker comprising a choke seal. JP 2003 243150 discloses a choke structure of a door for a high-frequency heating device. WO00/36878 discloses a microwave oven with a microwave seal for reducing leakage of microwave radiation. GB 2011770 discloses a door seal arrangement for high-frequency heating apparatus. US 4137441 discloses a microwave oven door seal. US 3767884 discloses an energy seal for a high frequency energy apparatus.

## Summary of a Few Exemplary Aspects of the Disclosure

An aspect of the present disclosure is directed to a choke configured to attenuate propagation of an electromagnetic (EM) wave between a cavity and a door adjacent to an opening of the cavity according to claim 1.

In other embodiments, the present disclosure is directed to a door for a radiofrequency (RF) oven including an RF choke. The door has a width of about 6 cm and is configured to attenuate RF frequencies of a band having a central frequency between 800-1000 MHz and a bandwidth of at least 200 MHz.

The drawings and detailed description which follow contain numerous alternative embodiments and examples. A summary of every feature disclosed is beyond the object of this summary section. For a more detailed description of exemplary aspects of the invention, reference should be made to the drawings, detailed description, and claims, which are incorporated into this summary by reference.

## Brief Description of the Drawings

Fig. 1A illustrates a schematic diagram of an oven including a choke system described herein;

Fig. 1B illustrates a schematic electrical diagram of an oven including a choke system described herein;

Fig. 2 illustrates a schematic profile of a double level cascade choke system in accordance with some embodiments of the invention;

Fig. 3A illustrates a schematic electrical diagram of an oven including a multi-level choke system in accordance with some embodiments of the present invention;

Fig. 3B illustrates a graph of the attenuation (dB) versus frequency for a single choke system described herein, and for two choke systems and three choke systems in accordance with some embodiments of the present invention;

Fig. 4 illustrates a side view diagram of an oven including a choke system in accordance with some examples described herein;

Fig. 5 illustrates an oven including a choke system in accordance with some examples described herein;

Figs. 6A-6D illustrate profiles of choke systems comprising choke component(s) having a mechanical wave attenuating structure which may be used in accordance to some embodiments of the invention;

Figs. 7A-7B illustrate a side view diagram of an oven including a plurality of choke systems in accordance with exemplary embodiments of the present invention;

Fig. 8A illustrates a choke profile having a cascade design for attenuating two different central frequencies in accordance with some embodiments of the present invention;

Fig. 8B illustrates a choke profile having a cascade design for attenuating a single central frequency in accordance with some embodiments of the present invention;

Fig. 8C presents simulation results of $Z_{in}$ using the two choke profiles illustrated in Figs. 8A and 8B;

Fig. 8D presents simulation results of $S_{21}$ using the two choke profiles illustrated in Figs. 8A and 8B;

Fig. 9 illustrates a choke profile having a cascade design for attenuating two different central frequencies in accordance with some embodiments of the present invention;

Figs. 10A, 10B, and 10C illustrate three dimensional choke system(s) in accordance with some examples of the present invention;

Fig. 11 is a three dimensional illustration of an oven cavity with a choke system in accordance with some examples described herein;

Figs. 12A-12L illustrate and present choke corners in accordance with some examples described herein and embodiments of the present invention; and

Figs. 13A and 13B illustrate exemplary oven configurations in which choke systems are disposed on both the door and the cavity wall facing the door, in accordance with some embodiments of the present invention.

Detailed Description

Reference will now be made in detail to exemplary embodiments of the invention and examples described herein. Some embodiments and examples are illustrated in the accompanying drawings. When appropriate, the same reference numbers are used throughout the drawings to refer to the same or like parts.

Some embodiments of the invention may be related to a choke system having a configuration adapted to attenuate RF waves within a given frequency range. The choke system may be employed to an oven that may utilize electromagnetic (EM) energy for processing a suitable object. For example, the oven may be a radiofrequency (RF) oven that may utilize RF energy, e.g., for processing food. An oven body (e.g., its cavity) may be closed by an oven door. Even when the door is closed, a gap (for example, 1-5 mm, e.g., 2.5 mm) may be formed between the cavity and the door which might result in leakage of electromagnetic energy, for example: RF energy, from the oven cavity. In some embodiments, at least some portions of the gap may be provided with one or more layers of material other than air, each may have different dielectric properties. In some embodiments, a choke may be provided at the interface between an oven door and an oven cavity which interface, if not fully closed, may fail to provide a barrier between the inside of the oven cavity and the outside of the oven cavity, as a result electromagnetic energy may leak outside the oven cavity. As used herein, the phrase "choke" includes more than one choke system (referred to herein as a "multi-level choke system"). For example, a two level choke system may comprise two choke systems etc. In some embodiments, the choke may be provided as part of the oven body. In some embodiments, the choke may be provided as part of the oven door. In some embodiments, a gasket may be provided in addition to the choke.

In one respect, the invention may involve apparatuses (e.g., ovens) for applying RF energy. In some embodiments, the RF energy may be applied inside the oven body (e.g., inside its cavity). In some embodiments, the RF energy may be applied at a single frequency or at a plurality of frequencies or within a frequency range (also referred herein as frequency band). The term electromagnetic energy, as used herein, includes any or all portions of the electromagnetic spectrum, including but not limited to, radio frequency (RF), infrared (IR), near infrared, visible light, ultraviolet, etc. For example, applied electromagnetic energy may include RF energy with a wavelength in free space of 100 km to 1 mm, which corresponds to a frequency of 3 KHz to 300 GHz, respectively. For another example, the applied electromagnetic energy may fall within frequency bands between 500 MHz to 1500 MHz or between 700 MHz to 1200 MHz or between 800 MHz - 1 GHz. Applying energy in the RF portion of the electromagnetic spectrum is referred herein as applying RF energy. Microwave and ultra high frequency (UHF) energy, for example, are both within the RF range. In some other examples, the applied electromagnetic energy may fall only within one or more Industrial, Scientific, and Medical (ISM) frequency bands, for example, between 433.05 MHz and 434.79 MHz, between 902 MHz and 928 MHz, between 2400 MHz and 2500 MHz, and/or between 5725 MHz and 5875 MHz. Even though embodiments are described herein in connection with the application of RF energy, these descriptions are provided to illustrate a few exemplary principles of the invention, and are not intended to limit the invention to any particular portion of the electromagnetic spectrum.

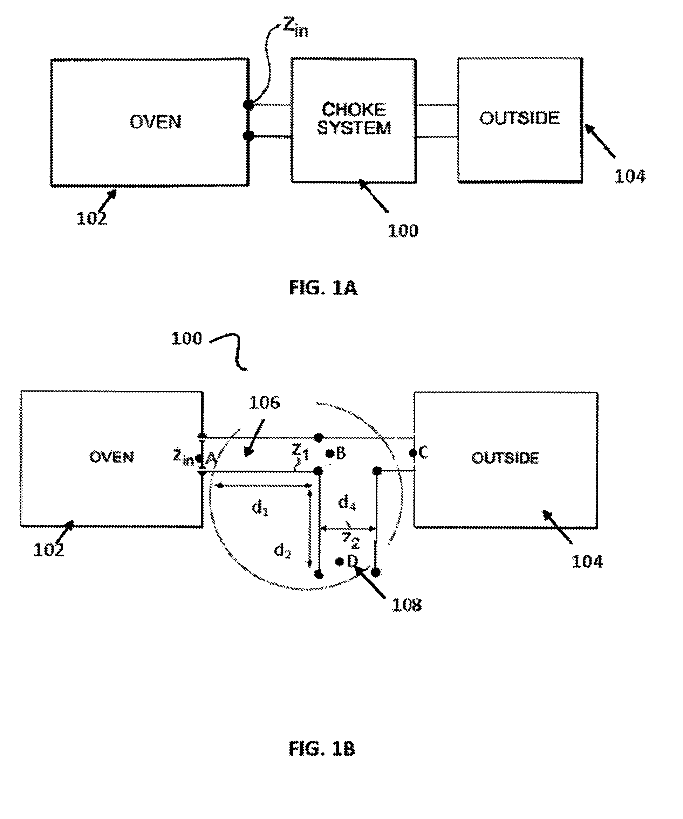

Reference is now made to Fig. 1A illustrating a schematic diagram of an oven including a choke system in accordance with some examples described herein. A choke system 100 may be provided between oven cavity 102 and outside world 104. In some examples, the shape and dimensions of choke system 100 may be configured such that an input impedance of the cavity/door interface, denoted as $Z_{in}$ in Fig. 1A, is low at a band of frequencies used to apply an EM energy to the cavity. In some examples, a low input impedance may reduce voltage arcing or sparks which may occur at the interface between the oven body and the door (e.g., in the vicinity of the choke). This may reduce, or even eliminate, carbonization that may occur due to arcing in the vicinity of choke system 100. The cavity input impedance may be calculated as:

$$(1) \quad Z_{in} = E_T/H_T ;$$

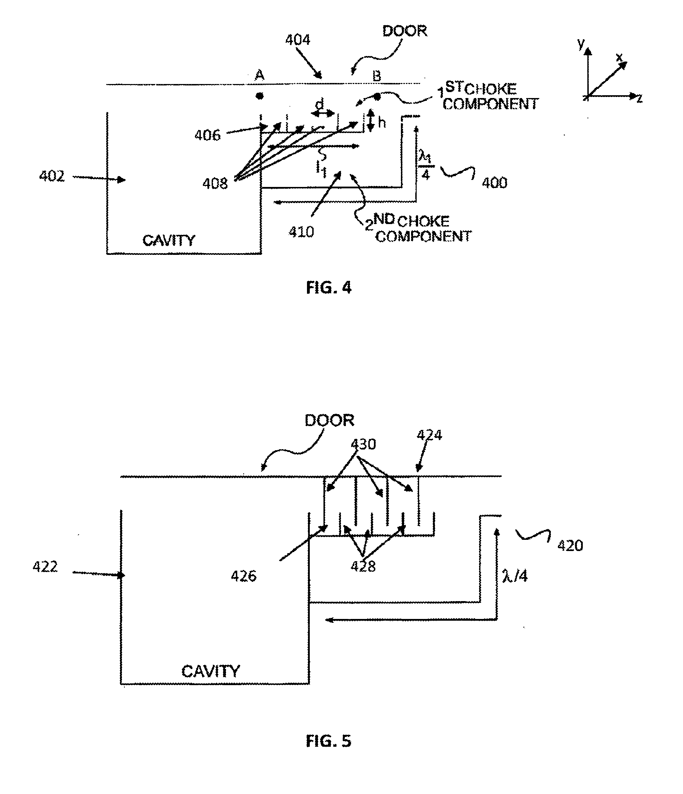

wherein, $E_T$ is the transverse electric field and $H_T$ is the transverse magnetic field. A transverse field may be defined by the direction of the opening. For example, in Fig. 4, a transverse surface may be defined as the x-y surface. In accordance with the Cartesian coordinate system illustrated in Fig. 4, $Z_{in} = E_x/H_y$.

In some examples, normalized cavity input impedance $Z_{in}/Z_c$ may be calculated, wherein $Z_G$ is the equivalent cavity/door waveguide impedance, and a low normalized cavity input impedance may be below 10, 5, or 1 (e.g., $Z_{in}/Z_c < 1$).

In some examples, choke system 100 may be configured to attenuate electromagnetic energy at a broadband of frequencies. In this application the term "broadband" may be interchangeable with the term "wideband." In some examples, choke system 100 may include a broadband choke, namely a choke that may be configured to reduce and/or prevent leakage of frequencies within a broad EM energy band. In some examples, a broadband of frequencies may refer to a band having a band of more than 5%, 10%, 20% of its central frequency (e.g., 200 MHz at a central frequency of 1 GHz). Exemplary broad bandwidths may include 150 MHz or more, 200 MHz or more, 400 MHz or more, or even 1 GHz or more. The central frequency of the attenuated (e.g., filtered) band may be of any value, including frequencies between 600 MHz and 5-10 GHz (e.g., 900 MHz, 2.45 GHz, or any other frequency). Exemplary bands may include the range of 400-1200 MHz, 600-1000 MHz, 500-900 MHz, 800-1000 MHz, etc.

Fig. 1B illustrates a schematic electrical diagram of an oven including a choke system in accordance with some examples described herein. Choke system 100 may have low input impedance ($Z_{in}$) (e.g., low impedance of the cavity/door interface, such as at the location denoted A in Fig. 1B). In some examples, choke system 100 may be designed such that a minimum transmission (of EM energy) may be obtain between oven cavity 102 (point A) and the outside world 104 (denoted as point C in Fig. 1B), such that leakage of energy from oven cavity 102 may be reduced or prevented. In some examples, choke system 100 may comprise a first choke component 106 (illustrated for example from point A to B) followed by a second choke component 108 (illustrated for example from point B to D). Second choke component 108 may be arranged substantially perpendicular to first choke component 106 thus reducing choke system 100 (and also the oven) dimensions.

In some examples, a short circuit may be produced at the edge of oven cavity 102 (denoted as point A in Fig. 1B), such that a minimum input impedance ($Z_{in}$) may be obtained at point A. By utilizing the cyclic behavior of transmission lines' impedance with respect to $\lambda/2$, by making:

$$(2) \quad d_1 + d_2 = \lambda/2 ;$$

wherein, A is the wavelength of the EM energy, thus the short circuit at point D (in Fig. 1B) may be "translated" to point A (in Fig. 1B).

The input impedance across choke system 100 may be expressed in accordance with the following equation:

$$(3) \quad Z_{inc} = jZ_c \tan \beta l ;$$

wherein, $\beta = 2\pi/\lambda$, $\lambda$ is the wavelength of the EM energy, $Z_c$ is the characteristic impedance of the relevant waveguide in which the wave propagates, and I is the distance across choke system 100. Equation (3) may be achieved by analytical calculation based on one or more simplifications including simplifications of the configuration illustrated in Fig. 1B.

In some examples, at the end of first choke component 106, as illustrated by point B in Fig. 1B, the calculated input impedance (according to equation (3)) may be:

$$(4) \quad Z_1 = Z_{inc}\left(l = d_1 = \frac{\lambda}{4}\right) \to \infty$$

Thus point B may be referred to as a cutoff. Since $Z_1$ may be referred to as a cutoff, any impedance (resistance) that is in series with it (e.g., the impedance of the second choke component) may not affect it.

In some examples, at the end of second choke component 108, as illustrated by point D in Fig. 1B, the calculated input impedance may be:

$$(5) \qquad Z_2 = Z_{inc}\left(l = d_1 + d_2 = \frac{\lambda}{2}\right) = 0;$$

thus, point B may be referred to as a short circuit.

In some examples, the voltage at the cavity side (e.g., at point A in Fig. 1B) may be denoted $V_{in}$, the input impedances of first choke component 106 and second choke component 108 are $Z_1$ and $Z_2$ respectively, and the voltage at the outside (e.g., at point C in Fig. 1B) may be denoted $V_{out}$ and may be expressed by the following equation:

$$(6) \qquad V_{out} = V_{in} \cdot \frac{Z_1}{Z_1 + Z_2} \Rightarrow S_{21} = \frac{V_{out}}{V_{in}} = \frac{Z_1}{Z_1 + Z_2}$$

In some examples, the impedance of second choke component 108 ($Z_2$) may be increased, such that the voltage at the outside($V_{out}$) may be reduced thus reducing leakage of energy from the cavity. Second choke component 108 may be a transmission line, thus its input impedance may be expressed by:

$$(7) \qquad Z_{2a} = j Z_c \tan \beta l^*;$$

$$(8) \qquad Z_c = Z_0 \frac{d'}{w_0};$$

which correspond to parallel plate waveguide, wherein d' is the thickness (height) of the waveguide (which corresponds to $d_4$ in Fig. 1B), $W_0$ is the width of the waveguide (not illustrated in Fig. 1B), and $Z_0$ is the characteristic impedance of the waveguide.

Thus, by keeping $d_4$ (which corresponds to d' in equation (8)) as wide as possible (subject to other design constraints) it may be possible to maintain broadband functionality when the tangential behavior became less dominant. In some examples, as $Z_c$ is increased, a broader bandwidth may be obtained. In accordance with equation (8), the width of second choke component 108 (denoted as $d_4$ in Fig. 1B) may influence the value of $Z_c$, thus a broader bandwidth may be examples obtained by increasing $d_4$ (thus increasing $Z_c$). In some examples, other designs may be employed in order to obtain broadband functionality.

In accordance with some examples, the dimensions of the first and second choke components (106 and 108) may be calculated in accordance with the central frequency of a filtered band (e.g., the attenuated band). The corresponding wavelength $\lambda$ may be determined via $\lambda = c/f$, where $\lambda$ is the wavelength, f is the frequency, and c is the propagating speed of the electromagnetic waves in the oven cavity and/or choke. For example, for a 900 MHz central frequency of the filtered band, the corresponding wavelength $\lambda$ may be 33.3 cm, and the length of the first and second choke components may be 8.33 cm.

Design of a single level choke system (e.g., a choke with one choke system) may be limited to the proximity of single central frequency, thus may narrow the width of the frequency band that may be attenuated by the choke. In embodiments, more than one choke systems (i.e., more than one choke system 100) is provided in order to attenuate a wider frequency band. In some embodiments, the plurality of choke systems may be designed to attenuate a frequency band having different central frequencies.

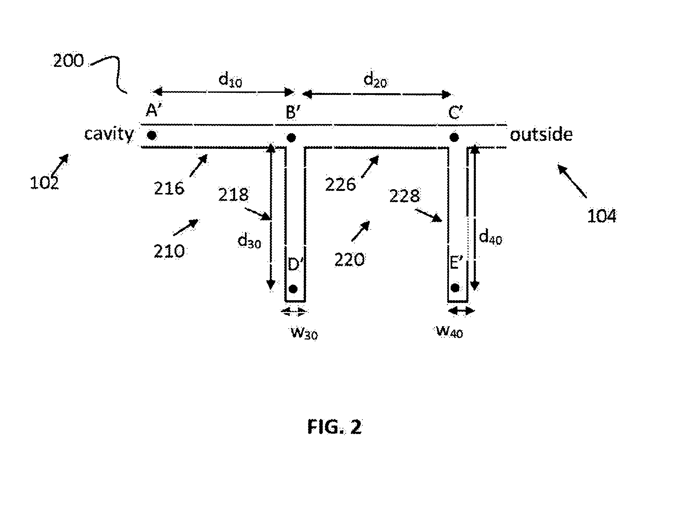

Reference is now made to Fig. 2 illustrating a multi-level choke system 200 in accordance with some embodiments of the invention. Multi-level choke system 200 comprises two choke systems 210 and 220 provided in a cascading formation (herein also referred to equivalently as "in cascade," "in cascade with," or "having a cascade design"). Each choke system (210 or 220) includes two choke components similar to the ones disclosed in Fig. 1B. Choke system 210 includes a first choke component 216 and a second choke component 218. Component 218 may be perpendicular to component 216. In similar manner, choke system 220 includes a first choke component 226 and a second choke component 228. Component 228 may be perpendicular to component 226. Component 216 may or may not be substantially similar to component 226 and component 218 may or may not be substantially similar to component 228. In some embodiments, the two choke systems may differ in dimensions and/or the number of choke components. In some embodiments, the two choke systems may comprise different materials (e.g., at least one of the choke systems may include a dielectric filler material to fill one or more of the systems components). In some embodiments, the two choke systems may be identical in at least one of their dimensions, number of choke components, and materials. For example, in some embodiments, the dimensions (e.g., $d_{10}$) of component 216 may be different from the ones of component 226 (e.g., $d_{20}$) and/or the dimensions of component 218 (e.g., $d_{30}$ and $d_{40}$) may be different from the ones of component 228. In some embodiments, choke system 210 may be designed to attenuate a frequency band having a central frequency $f_1$ and choke system 220 may be designed to attenuate a frequency band having a central frequency $f_2$. Central frequency $f_1$ may be identical with or different from central frequency $f_2$.

Choke system 220 in cascade with choke system 210 may result in cut off at point C' in series to short circuit at point E'. Since choke system 220 may be in series to choke system 210, which may exhibit cut-off at point B', anything that is in series to a cut-off may be less significant or its influence may be reduced.

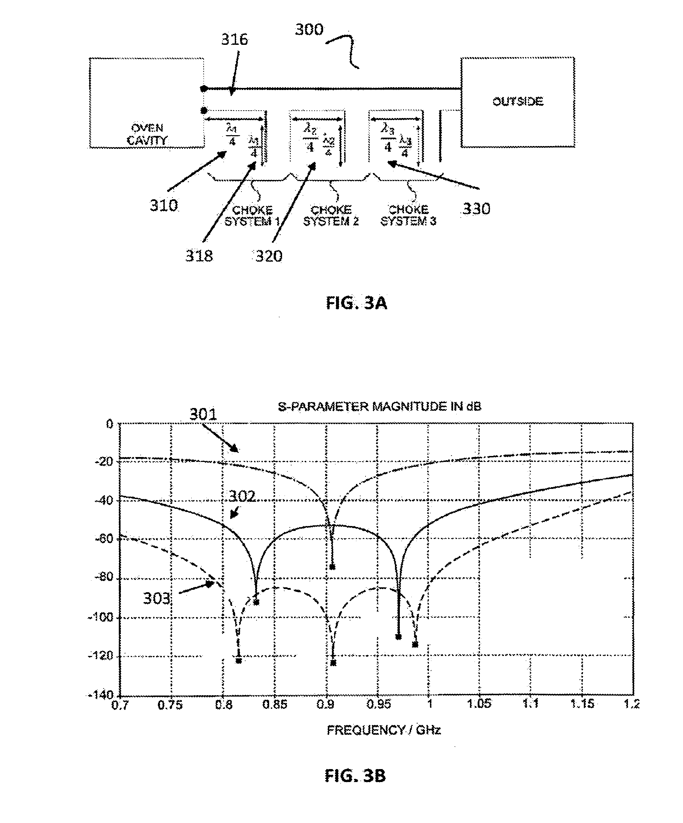

In some embodiments, a broadband choke may be achieved by tuning the multi-level choke system. Some examples for the benefits of a multi- level choke system are disclosed with respect to Fig 3B. Tuning the multi level choke system may be achieved by changing at least one parameter or dimension within the multi-level choke system. For example, tuning may be performed by changing the total length of one choke system, for example each of $d_{10}$ and $d_{30}$ in system 210 to be equal to $\lambda_1/4$ at central frequency $f_1$ and each of $d_{20}$ and $d_{40}$ in system 220 to be equal to $\lambda_2/4$ at central frequency $f_2$. In addition, tuning may include changing the width $w_{30}$ and/or $w_{40}$ of components 218 and 228.

In embodiments, a plurality of choke systems are provided in the oven. Fig. 3A illustrates a multi-level choke system in accordance with some embodiments of the invention. Multi-level choke system 300 may comprise three choke systems 310, 320 and 330 arranged in a cascading form. In some embodiments, choke systems 310, 320 and 330 may be designed to attenuate a band having corresponding central frequencies $f_1$, $f_2$, and $f_3$ with corresponding wavelengths $\lambda_1$, $\lambda_2$, and $\lambda_3$. In some embodiments each choke system may comprise at least two choke components. For example, choke system 310 may include component 316 and component 318. In some embodiments, component 316 may be substantially perpendicular to component 318. The length of each component may be equal to $\lambda_1/4$. In some embodiments, multi-level choke system 300 may increase the total attenuated bandwidth. For example, the central frequency of the individual choke system within the plurality of chokes may be 900 MHz, 814 MHz, and 987 MHz respectively.

Simulation results of the attenuation (dB) versus frequency, for frequency band of 700-1200 MHz, are presented in Fig. 3B. Three attenuation graphs of optional choke systems are presented; the simulations were performed assuming transverse propagation of the incident wave. Graph 301 presents simulation results performed for a single choke system, for example choke system 100 illustrated in Fig. 1B having a central frequency at 906 MHz. Graph 302 presents simulation results for a two-level choke system, for example system 200 illustrated in Fig. 2 having central frequencies at 832 MHz and 971 MHz. Graph 303 presents simulation results for a three-level choke system, for example system 300 illustrated in Fig. 3A having central frequencies at 815 Mhz, 906 MHz, and 987 Mhz. As can be seen, the overall frequency attenuation may be raised (and the RF energy leakage may be decaying) with the number of cascading choke systems in a multi-level system.

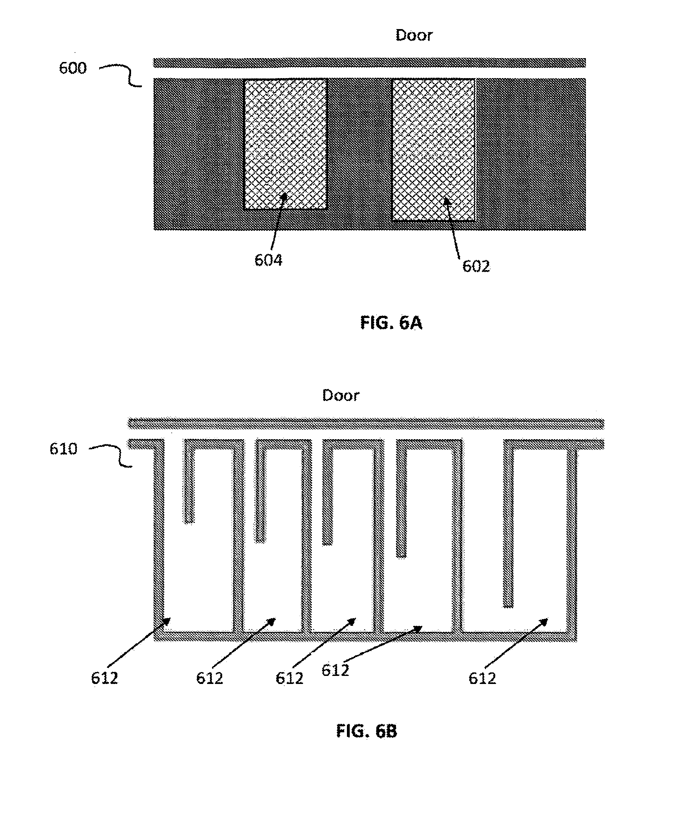

In some embodiments, the first choke component (e.g., component 216, or 316) may have a mechanical wave attenuating structure. "Wave attenuating structures," as suggested from their name, may include structures (e.g., waveguides) constructed to attenuate (e.g., slow down) EM or RF waves. Mechanical wave attenuating structures are mechanical assemblies design to attenuate EM waves (e.g., by reducing its effective wavelength ($\lambda_{eff}$)), for example, by mechanical means. In some embodiments, the mechanical means may not include additional dielectric material with high losses. Mechanical means may include conductive elements (e.g., reactive elements) attached to the waveguide component designed to extend the electrical path in which the EM wave travels. Extending the electrical path of the EM wave may reduce its effective wavelength ($\lambda_{eff}$), thus reducing the dimension of the choke. In some embodiments, mechanical wave attenuating structures may form a labyrinth structure. Some examples of mechanical wave attenuating structures are presented in Figs. 6A-6D. In some embodiments, a wave attenuating structure may be used in the second choke component (e.g., component 208, or 318) or any other choke.

Reference is now made to Fig. 4 illustrating a side view diagram of an oven including a choke system in accordance with some examples described herein. In some examples, oven cavity 402 may include a first choke component with a wave attenuating structure. Choke system 400 may be located in cavity 402 peripheral areas (e.g., in oven body). Door 404 may seal cavity 402 and choke system 400. Door 404 may further include a gasket (not illustrated) configured to further block the RF energy leakage and/or to block the escape of heat, if heat convection cooking is applied together with the RF energy application.

In some examples, choke system 400 may include a first choke component having a mechanical wave attenuating structure 406 (referred to herein as "first choke component 406" or "mechanical attenuating structure 406") and a second choke component 410. Mechanical wave attenuating structure 406 may comprise a series of reactive elements 408 which may perform as an effective quarter-wave transformer. In some examples, a discontinuity (e.g., cut-off) at point B may be translated to a short circuit at point A. First choke component 406 may be provided with a plurality of reactive elements 408 (for example in the form of slots or teeth) situated perpendicular to the propagation direction of the EM wave (e.g., the Z-direction). The plurality of reactive elements 408 (e.g., slots or teeth) may form the wave attenuating structure 406. Plurality of reactive elements 408 may reduce the propagating speed of the wave (e.g., the EM wave). By reducing the propagating speed of the wave from c to c' (c'<c), the reactive elements 408 may reduce the effective wavelength ($\lambda_{eff}$) since the effective wavelength may be proportional to the propagating speed, e.g., $\lambda$=c/f. In some examples, the dimension of first choke component 406 (denoted as $l_1$ in Fig. 4) may be, for example, less than a quarter of the wavelength of the central frequency. For example, for a 900 MHz central frequency, the corresponding wavelength $\lambda$ may be 33.3 cm, and the length of the first choke component may be less than 33.3/4 = 8.33 cm, for example 2, 3, or 4 cm, or any intermediate value between 0 and 8.33 cm. In some examples, wave attenuating structure 406 may reduce the dimension of the choke component by, e.g., 2, 3, or 4 folds. In some examples, choke system 400 may be provided at the oven cavity perimeter, thus the size of the choke components and/or choke system 400 may influence the overall size of the oven. Accordingly, implementing a choke component or a choke system having the aforementioned wave attenuating structure, which may have a more compact size than one not having a wave attenuating structure, may reduce the overall oven dimensions. Other considerations that may affect the size of first choke component 406 may include limitation due to production methods and costs.

In some examples, second choke component 410 may be folded (e.g., so that it overlaps with first choke component 406), for example, as illustrated in Fig. 4, which may further reduce the dimension of choke system 400 along the Z axis. In some embodiments, a wave attenuating structure may be used for second choke component 410 (e.g., a plurality of slots may be provided in second choke component 410).

In some examples, a wave attenuating structure 426 may be partially located at cavity 422 peripheries and partially at an oven door 424, as illustrated for example in Fig. 5. In some examples, a plurality of reactive elements in the form of prongs 430 may be provided on oven door 424. Prongs 430 provided on oven door 424 may match the plurality of reactive elements 428 (e.g., slots) provided on oven cavity 422 to form a comb structure. When the door is in a closed position, there may be space remaining between the tips of prongs 430 and the deepest portions of slots 428. In some examples, slots 428 may be on the surface of oven door 424 and prongs 430 on the wall of oven cavity 422.

The number of reactive elements (e.g., teeth, prongs and/or slots) may vary (e.g., 2, 6 or 8, 10, 20, or more). In some examples, the number of reactive elements may vary from one choke component to another. In some examples the number of reactive elements may be used to tune the choke system. In some examples, the height (depth) (denoted as "h" in Fig. 4) of each reactive element may be in the range of 0.1-5 cm (e.g., 1 cm). In some examples, the reactive elements may be of different heights. In some examples, the height of the reactive elements may be the same within a choke component but may be different between one choke components and another. In some examples, the distance between the reactive elements may be in the range of 0.5-5 mm (e.g., 2 mm). In some examples, the distance between the reactive elements may be proportional to the wavelength of the attenuated RF energy, for example: $\lambda$/10, $\lambda$/20 or $\lambda$/50. In some examples, the distance (denoted as "d" in Fig. 4) between the reactive elements may be the same within a choke component but may be different between one choke component and another. In some examples, the thickness of the reactive elements may be in the range of 0.5-5 mm, e.g. 2 mm. In some examples, the thickness of the reactive elements may be proportional to the wavelength of the attenuated RF energy, for example: $\lambda$/10, $\lambda$/20, or $\lambda$/50.

In some examples, the depth (denoted as h in Fig. 4) of the reactive elements (e.g., teeth, slots or prongs) may affect the ability of the choke to ensure minimum input impedance $Z_{in}$ (which may result in short circuit when $Z_{in}$ equals zero) at point A in Fig. 4. In some examples, the thickness of the reactive elements (e.g., slots or the teeth) may be defined by mechanical and manufacturing considerations in addition to or alternative to electrical considerations (e.g., the formability and strength of the material comprising the choke). Wave attenuating structure 406 may have 4 slots (as illustrated in Fig.4); however other numbers of slots may be considered.

Reference is now made to Figs. 6A-6D illustrating various wave attenuating structures which may be used, in accordance with some embodiments of the invention. Fig. 6A illustrates a choke system 600 having a wave attenuating structure which may comprise two components 602 and 604 comprising dielectric materials with low losses, for example $\varepsilon'$ between 2 to 20 (e.g., $\varepsilon'=10$). Choke system 600 is a mechanical wave attenuating structure, wherein the two components 602 and 604 may be configured to reduce the size of reactive elements. Component 602 may be designed to attenuate a frequency band having a central frequency f1, and thus may comprise an insert from material M1 having dimensions d1 and h1 (not illustrated). Component 604 may be designed to attenuate a frequency band having a central frequency f2, and thus may comprise an insert from material M2 having dimensions d2 and h1 (not illustrated). Components 602 and 604 may be constructed from similar materials and/or may have similar dimensions.

Figs. 6B-6D illustrate designs of mechanical wave attenuating structures which may be used in accordance with some embodiments of the invention. A multi-resonator design is illustrated for example in Fig. 6B. Choke system 610 may comprise a plurality of reactive element (e.g., in the form of resonators 612) acting as wave attenuating structures. Resonators 612 may have different dimensions and may be design to attenuate different frequency bands with different central frequencies, as illustrated. In some embodiments, at least two resonators may have the same dimensions in order to enhance the blocking of a certain frequency band. Choke system 610 is illustrated with 5 resonators. However, the invention is not limited to any particular number of resonators.

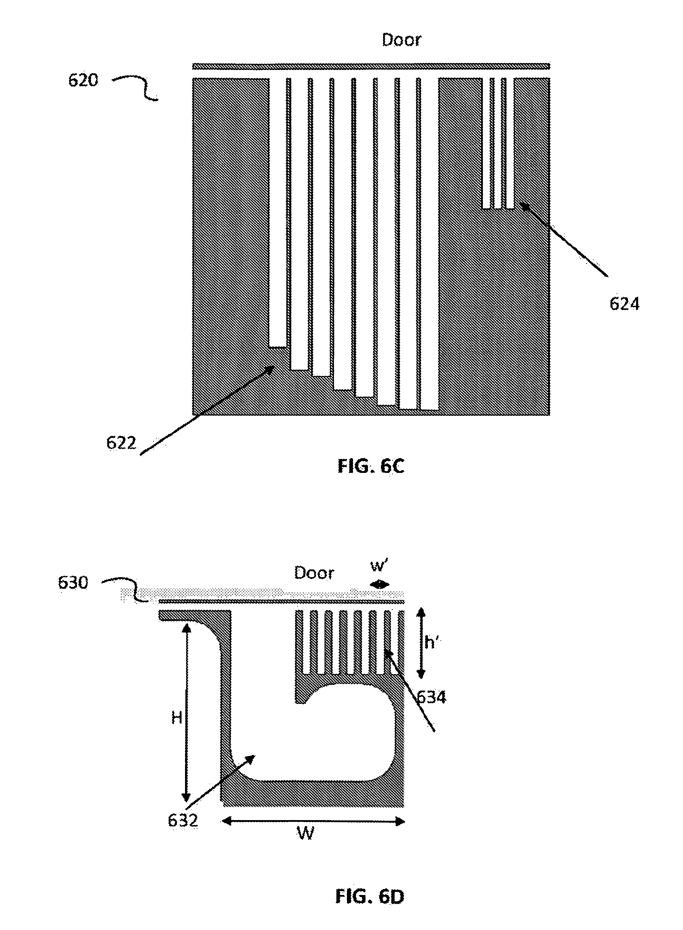

Fig. 6C illustrates choke system 620 comprising two multiple reactive elements 622 and 624, in accordance with some embodiments of the invention. Each of multiple reactive elements 622 and 624 may be designed to block a different frequency band with a different central frequency.

Reference is now made to Fig. 6D which illustrates a profile of choke system 630 having similar electrical features as choke system 400 illustrated for example in Fig. 4. Choke system 630 may include two choke components 632 and 634. First choke component 632 may be a waveguide 632 that may be a long straight waveguide, In some embodiments, in order to reduce the dimensions the waveguide, choke component 632 may be folded such that the main characters of the waveguide may be maintained. Perturbations from or imperfections in the straight waveguide may be compensated for by changing the dimensions of the folded waveguide using simulations. Second choke component 634 may include or be a wave attenuating structure. In some embodiments, wave attenuating structure of component 634 may be designed such that the height (depth), denoted as h', and the distance between reactive elements 636 (denoted as w') may be derived from $\lambda/4$ of the central frequency. Component 632 may be a folded wave guide designed such that the width W plus the high H may be equal to $\lambda/4$. The dimensions of component 634 may be derived from the same $\lambda/4$ as the dimension of component 632, thus the dimensions of components 632 and 634 may change according to the wavelength of the central frequency of the attenuated band.

A plurality of choke systems (e.g., choke systems 1, 2, and 3) having a wave attenuating structure are provided in cascade arrangement. In some embodiments, each choke system may be designed in accordance with a different central frequency, potentially also increasing the attenuated bandwidth. A wave attenuating structure may be used in the first choke component of each of the plurality of choke systems. In some embodiments, the wave attenuating structure may be used in the first and/or second choke components of each of the plurality of choke systems. In some embodiments, the wave attenuating structure may be used in the first choke component of one or more of the plurality of choke systems and in the second choke components of one or more of the other plurality of choke systems.

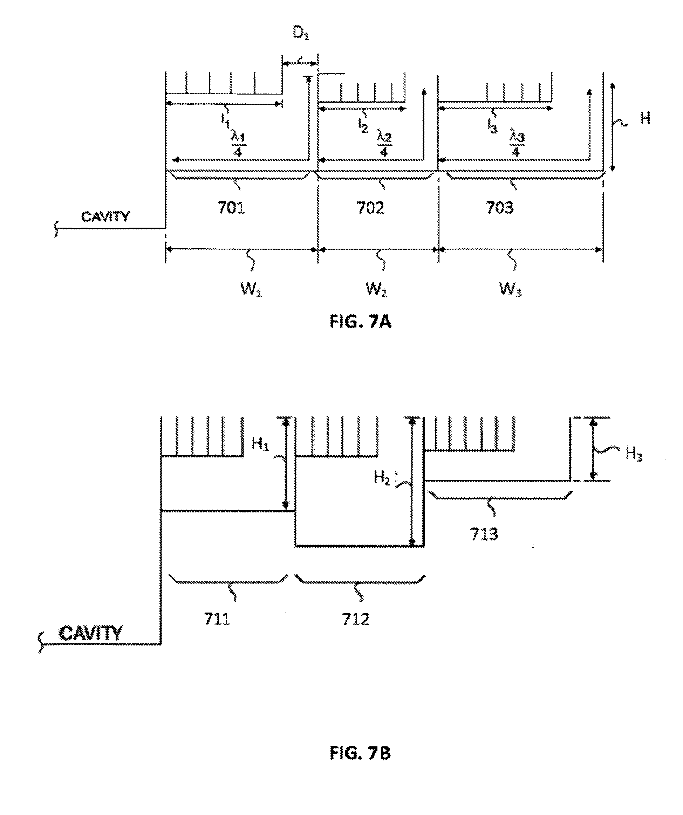

In the embodiment illustrated in Fig. 7A, the dimension of the first choke component (denoted as l1, l2, l3) of each of the plurality of choke systems (denoted as 701, 702, and 703) may be less than the quarter wave ($\lambda/4$) of the central frequency of each of the plurality of choke systems. For example, the dimensions l1, l2, and l3 may be 3 cm, 3.5 cm, and 4 cm, respectively. In some embodiments, the dimensions of the first choke component (denoted as l1, l2, l3) of each of the plurality of choke systems may be similar or identical, e.g. 3 cm.

In some embodiments, the height (denoted as H in Fig. 7A) of each of the plurality of choke systems (e.g., choke systems 701, 702, and 703, may be similar or identical (for example as illustrated in Fig. 7A). In some embodiments, the height of each of the plurality of choke systems may be different. For example, choke systems 711, 712, and 713 may have heights H1, H2, and H3, respectively, as illustrated in Fig. 7B. In some embodiments, the width (denoted as W1, W2 and W3 in Fig. 7A) of each of the plurality of choke systems, e.g. choke systems 701, 702, and 703, may be different (for example as illustrated in Fig. 7A) or identical. It will be apparent to a person skilled in the art that, in accordance with the design requirements, the height and/or width of each choke system may be determined so that the length of the second choke component of each choke system corresponds to $\lambda/4$ of the central frequency of that choke system. As described above in reference to Fig. 1B, the dimensions of the second choke component of each of the plurality of choke systems may influence and/or determine the bandwidth of the choke system. Accordingly, the dimensions (e.g., D1 for example as illustrated in Fig. 7A) of the second choke component may be determined in accordance with the desired bandwidth.

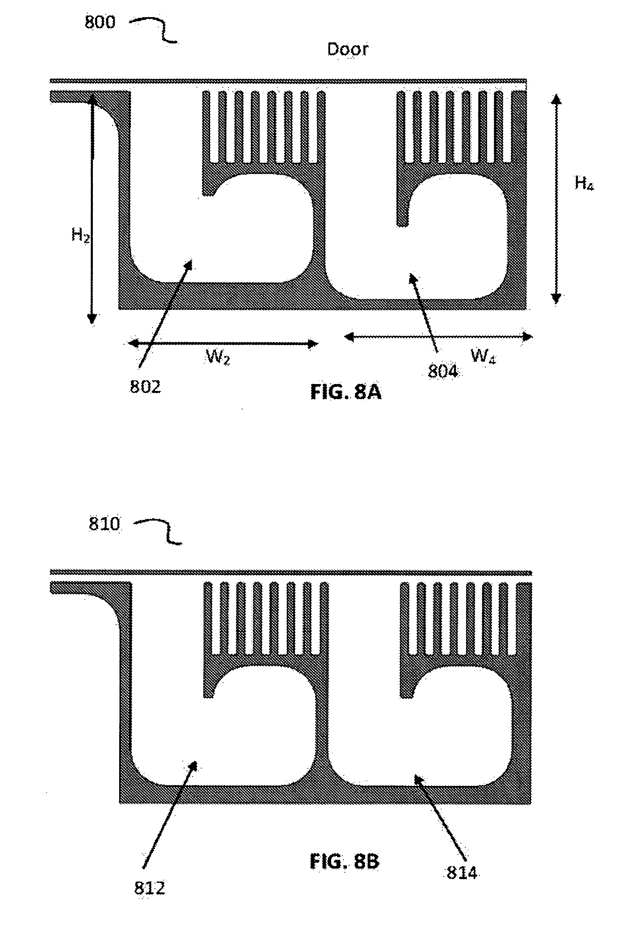

An exemplary profile of a multi-level choke system 800 having a cascade design comprising two choke systems 802 and 804, each designed to attenuate a different central frequency, is illustrated in Fig. 8A, in accordance with some embodiments of the invention. In choke system 802, the height and width of the folded waveguide (denoted as $H_2+W_2$) may be equal to $\lambda_1/4$ of central frequency $f_1$, and in choke system 804, the height and width of the folded waveguide (denoted as $H_4+W_4$) may be equal to $\lambda_2/4$ of central frequency $f_2$. Choke systems 802 and 804 may be similar to choke system 630. Choke system 802 may be designed to attenuate a frequency band having central frequency $f_1$, for example, approximately 830 MHz. Choke system 804 may be designed to attenuate a frequency band having central frequency $f_2$, for example, approximately 970 MHz.

Another exemplary multi-level choke system 810 having a cascade design, is illustrated in Fig. 8B, in accordance with some embodiments of the invention. Multi-level choke system 810 comprises two choke systems 812 and 814. Choke systems 812 and 814 may be similar to choke system 630. Choke systems 812 and 814 may be designed to attenuate similar or the same frequency band having similar or the same central frequency, thus may have similar or the same height and width and similar or the same wave attenuating structure dimensions. For example, choke systems 812 and 814 may have substantially the same dimensions.

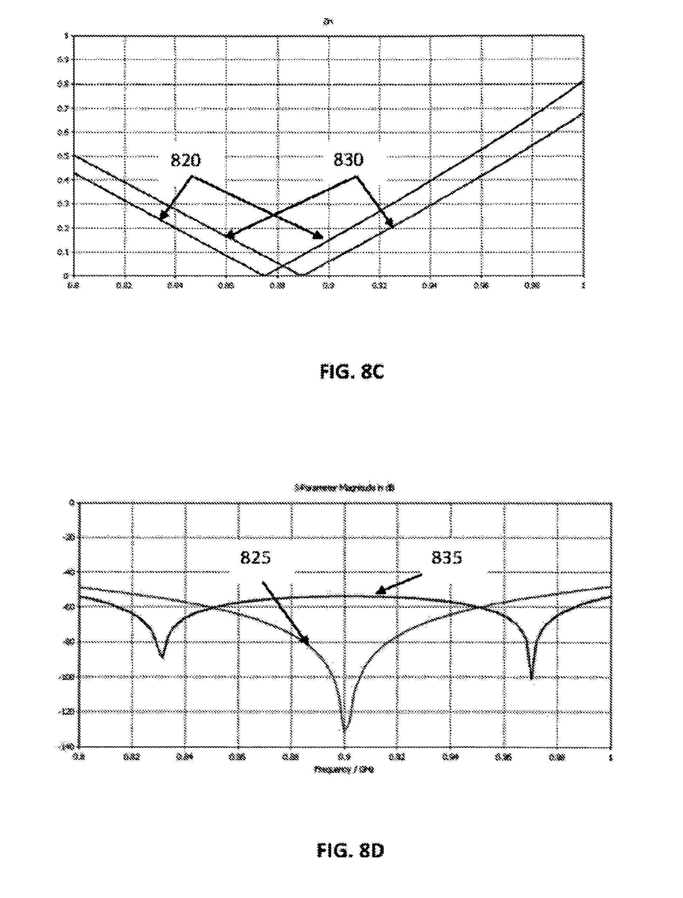

Reference is now made to Figs. 8C and 8D that present computer simulation results of the electric parameters normalized cavity input impedance $Z_{in}/Z_c$ and $S_{21}$ for multi-level choke systems 800 and 810. $Z_{in}$ may be defined by equation (1) and $S_{21}$ may be defined by equation (6). Multi-level choke system 810 was designed to attenuate the central frequency 900 MHz. The simulations were performed assuming transverse propagation of the incident wave. Fig. 8C presents two $Z_{in}$ (f) graphs 820 and 830 showing the input impedance vs. frequency. Graph 820 presents an ideal cavity behavior (e.g., a cavity having a choke which may not influence its boundary conditions) for multi-level choke system 810 and graph 830 presents ideal cavity behavior for multi-level choke system 800. Both choke systems 810 and 820 may have minimum normalized $Z_{in}$ in the central frequency ($Z_{in}$= approx. 0) and have values smaller than 1 for at least one frequency in the frequencies band. Fig. 8D presents the reflection coefficient $S_{21}$ calculated for both multi-level choke systems (800 and 810) vs. frequency. The coefficient value $S_{21}$ presented in dB may be correlative to the ability of the choke to attenuate the frequencies in a frequency band. The lower the dB value of $S_{21}$, the stronger the decay of the EM waves in the choke. As may be expected, the frequencies having the lower dB values are the central frequencies of each choke system. Graph 825 presents the simulated $S_{21}$ of multi-level choke system 810 having a single central frequency at 900 MHz. Graph 835 presents the simulated $S_{21}$ of choke system 800 having two central frequencies at 830 MHz and 970 MHz.

In some embodiments, it may be required to further reduce the size of the choke component or choke system. As discussed above, the dimension of a choke component may be reduced by reducing $\lambda_{eff}$, thus the dimension of the choke component may be less than $\lambda/4$. In some embodiments, a dielectric material may fill the volume of one or more choke components, thus obtaining $\lambda_{eff} = \lambda/\sqrt{\varepsilon}$. The material may be any dielectric material having low losses, for

example: $\varepsilon' = 10$. Additional considerations for the filling material may include: the weight of the material, the ability to mold it into the folded choke component, high temperature resistance (e.g., more than 300°C) and/or other environmental resistances (e.g., chemical stability).

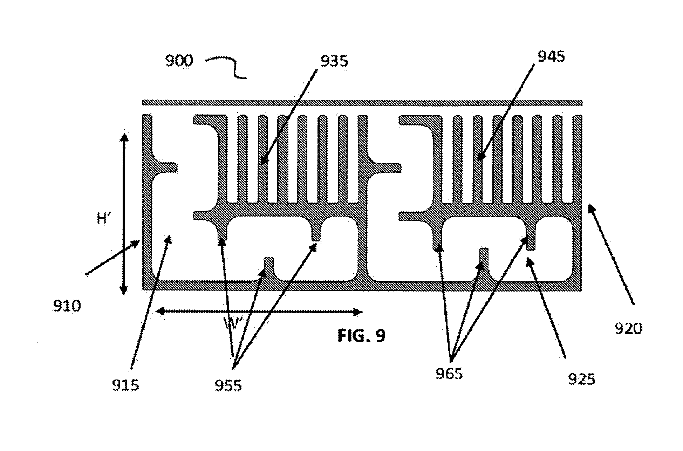

In some embodiments, the second choke component may include a wave attenuating structure and may be folded. The second wave attenuating structure (e.g., the second choke component having a wave attenuating structure) may allow further tuning of $Z_{in}$ and $S_{21}$. Exemplary folded choke components having a wave attenuating structure are illustrated in Fig. 9, in accordance with some embodiments of the invention. Choke components 915 and 925 in choke systems 910 and 920 may have reactive elements 955 and 965 (e.g., in the form of teeth). In some embodiments, the distance between reactive elements 955 and 965 may be in the range of 5-25 mm (e.g., 20 mm). In some embodiments, the distance between the reactive elements may be proportional to the wavelength of the attenuated RF energy, for example: $\lambda/5$, $\lambda/10$, $\lambda/20$ or $\lambda/50$. In some embodiments, the distance between the reactive elements may be the same within a choke component but may be different between one choke component and another. In some embodiments, the thickness of reactive elements 955 and 965 may be in the range of 0.5-5 mm, e.g. 2 mm. In some embodiments, the thickness of the reactive elements may be proportional to the wavelength of the attenuated RF energy, for example: $\lambda/10$, $\lambda/20$ or $\lambda/50$. In some embodiments, the depth (height) of the reactive elements may be proportional to the wavelength of the attenuated RF energy, for example: $\lambda/5$, $\lambda/10$, $\lambda/20$ or $\lambda/50$.

In some embodiments, choke components 915 and 925 may be folded waveguides (as illustrated). In some embodiments, first choke components 935 and 945 may have a wave attenuating structure (as illustrated). In some other embodiments, first choke components 935 and 945 may not have a wave attenuating structure. Multi-level choke system 900 may comprise two choke systems 910 and 920 designed to attenuate a frequency band (e.g., 700-1000 MHz, 500-700 MHz) having two central frequencies $f_1$ and $f_2$ (e.g., 725 MHz and 965 MHz).

In some embodiments, the height (denoted as H' in Fig. 9) of each of the plurality of choke systems within a multi-level choke system (e.g., choke systems 910 and 920, may be identical, for example as illustrated in Fig. 9). The height (denoted as H' in Fig. 9) may be in the range of 1.5-6 cm, e.g. 2.5 cm, 4 cm, 4.5 cm. In some embodiments, the height of each of the plurality of choke systems may be different. In some embodiments, the height of each of the plurality of choke systems may be proportional to the wavelength of the attenuated RF energy, for example: $\lambda/5$ or $\lambda/10$.

In some embodiments, the height of a choke system having a wave attenuating structure in its second choke component (e.g., choke system 910 and 920 illustrated in Fig. 9) may be smaller compared to a choke system not having a wave attenuating structure in its second choke component (e.g., choke system 802 and 804 in Fig. 8A), e.g. H' may be shorter than $H_2$ or $H_4$. In some embodiments, H' may be shorter than $H_2$ or $H_4$ by 20%, 30%, 40% or 50%. In some embodiments, the width (denoted as W') of a choke system having a wave attenuating structure in its second choke component (e.g., choke system 910 illustrated in Fig. 9) may be smaller compared to a choke system not having a wave attenuating structure in its second choke component (e.g., choke system 802 illustrated in Fig. 8A - denoted $W_2$ in Fig. 8A).

In some embodiments, a choke may be operable to reduce and/or prevent EM leakage of different incident angles. Waves leaking from a cavity may not be restricted to any specific propagating direction, and may include transverse and non-transverse waves. Since a non-TEM (TEM - Transverse Electro Magnetic) mode may be considered as a composition of non-transverse TEM modes, non-transverse waves may be excited by introducing non-TEM modes.

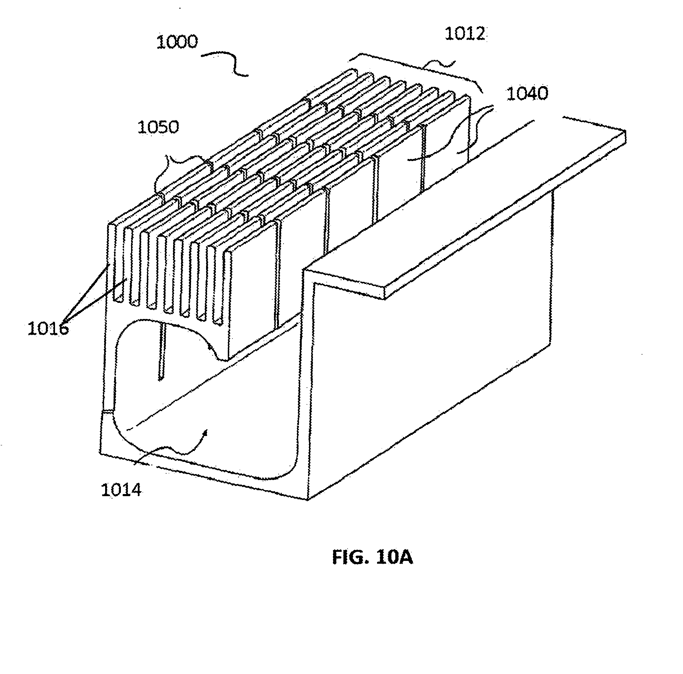

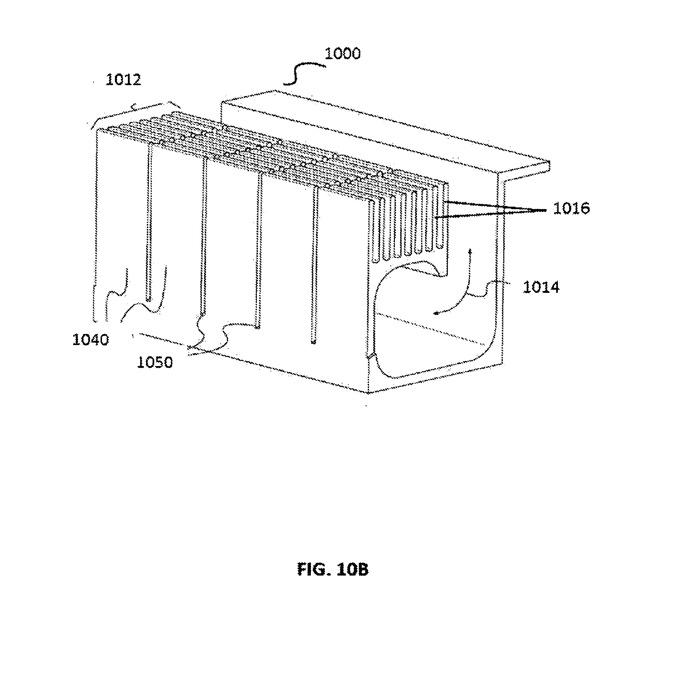

In some embodiments, interferences with the electrical path of the waves may be implemented. The interferences may be achieved by creating a mechanical discontinuity by cutting slots in the choke. Reference is now made to Fig. 10A illustrating a choke system in accordance with some examples described herein. A side view of choke system 1000 is illustrated in Fig. 10B in accordance with some examples described herein. Choke system 1000 may be similar to choke system 630 illustrated for example in Fig. 6D. Choke system 1000 may comprise a wave attenuating choke component 1012 and a folded choke component 1014. In some examples, choke system 1000 may be operable to reduce and/or prevent EM leakage of different incident angles. In some examples, one or more of reactive elements 1016 (e.g., slots) may be divided into sections 1040 (e.g., reactive elements 1016 may be provided with slits 1050). The distance between two slits may be in the range of 1-5 cm (e.g., 2 cm). The distance between two slits may be less than a typical wavelength of the EM energy delivered to the cavity, for example, in the range of $\lambda/10$ or $\lambda/15$. In some examples the width of the slits may be in the range of $\lambda/100$ or $\lambda/150$. In some examples, a reactive element provided with slits may form a discontinuous structure so that a wave of different incident angles may be attenuated as well.

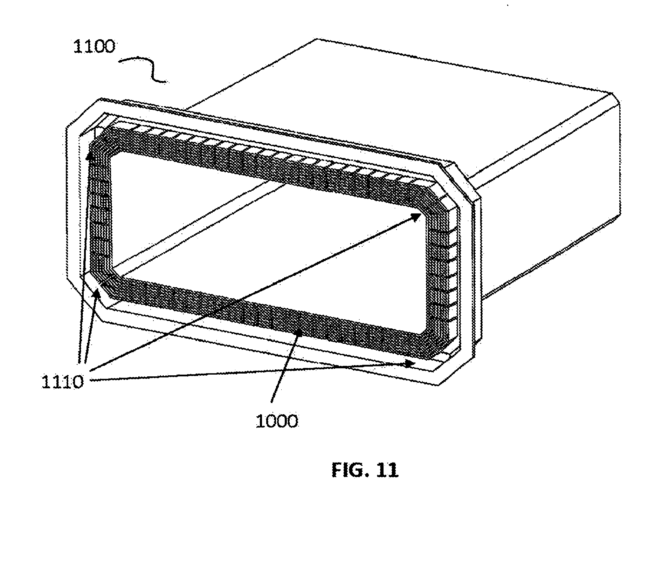

In some examples described herein, choke system 1000 may be provided on an oven cavity 1100, for example as illustrated in Fig. 11.

In some embodiments, a cover may be added to the choke system to keep the choke clean and/or to add additional blocking of the convection heating when convection heating is applied with the RF heating. The cover may be a dielectric material (which may be referred to as dielectric cover) glued to the choke surface and may touch the oven chassis. In some embodiments, the dielectric property $(\varepsilon')$ of the cover material may be in the range of 1.5-5 (e.g., $\varepsilon'=2.2$). In some embodiments, the cover addition may improve the blocking of the RF waves as the cover may be within the electrical path of the RF wave.

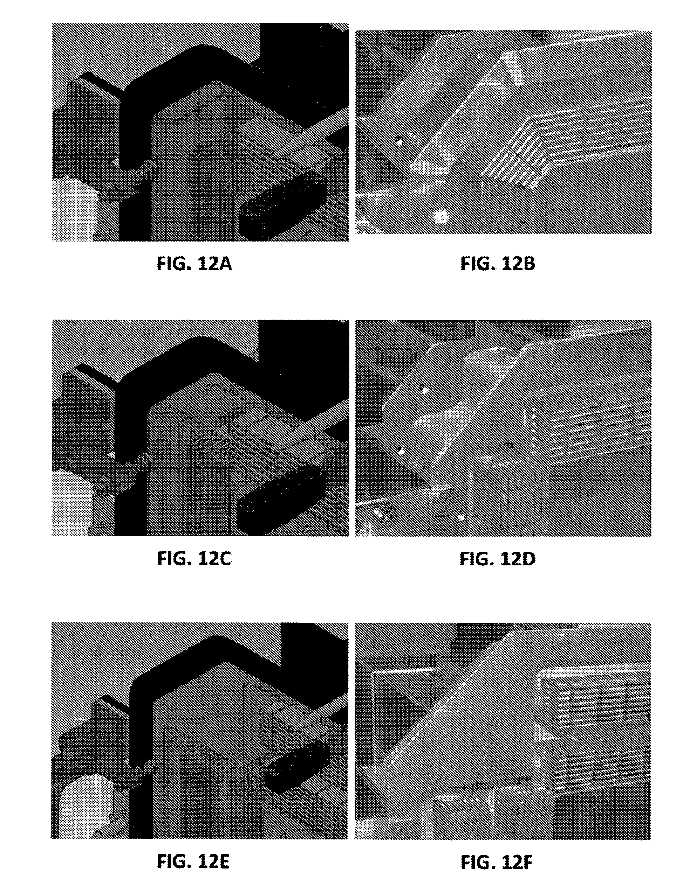

In some embodiments, one or more corners of oven cavity may be covered by one or more chokes. The oven corner may have a round shape, a truncated shape, a chamfered corner, or be absent altogether. Various choke corners are illustrated and presented in Figs. 12A-12L. Fig. 12A illustrates an example of a single level choke with chamfered corner; the photograph of the oven's corner illustrated in Fig. 12A is presented in Fig. 12B. Fig. 12C illustrates an example of a single level choke not having any corners; the photograph of the oven's corner illustrated in Fig. 12C is presented in Fig. 12D. A double level choke system having no coroners, in similar manner to the one presented in Figs. 12C and 12B, is illustrated in Fig. 12E and presented in the photograph in Fig. 12F.

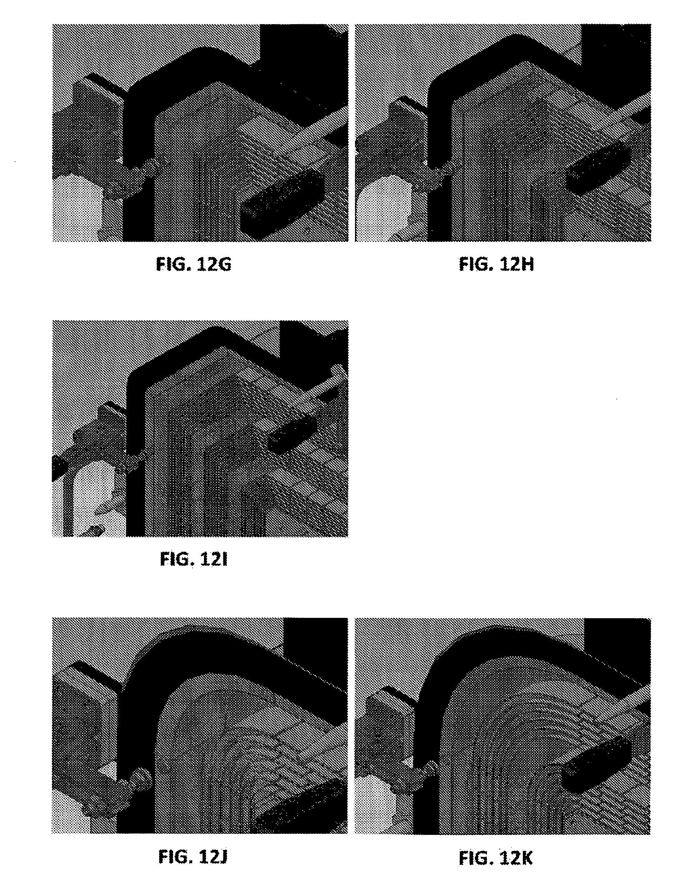

In some embodiments a chamfered design may be applied to the chokes corner. In chamfered design the corner may be chamfered. Fig. 12G illustrates an example of a single level choke with a chamfered corner. The chamfered design may be applied to multi-level choke systems as well. Fig. 12H illustrates a double-level choke system and Fig. 12I illustrates a triple-level choke system with a chamfered corner.

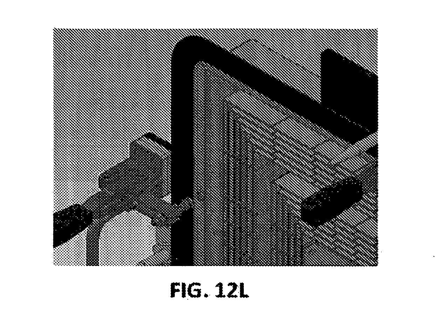

The choke may include a round corner. For example, Figs. 12J illustrates an example of a single level choke and Fig.12K illustrates a double-level choke system with a round corner. Fig. 12L illustrates a double-level choke system with a truncated coroner, similar to the single-level choke that was illustrated in Fig. 12A.

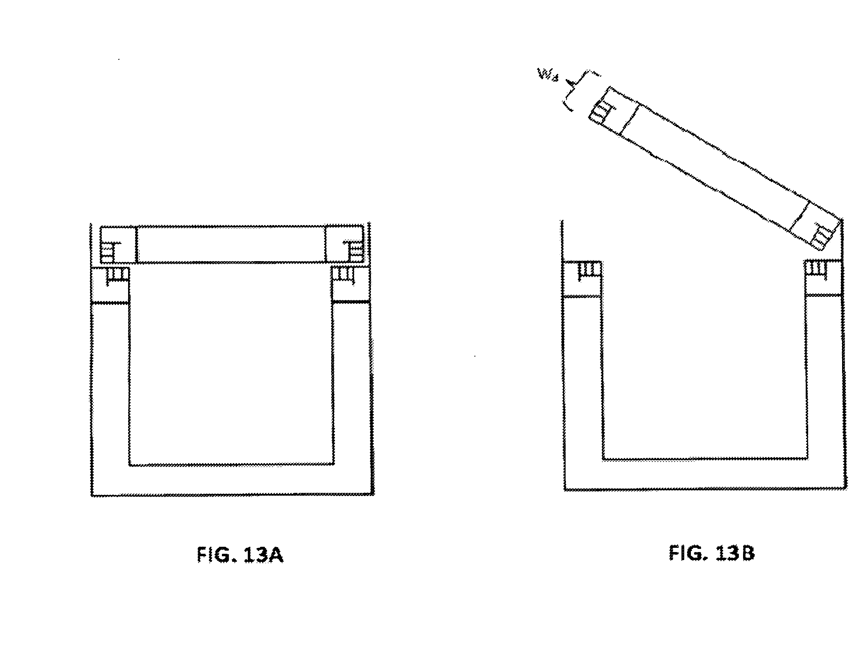

Although the embodiments and examples discussed above and illustrated in, e.g., Fig. 10 and/or Figs. 12A-12L are shown and described as having chokes on the oven body (e.g., cavity wall) facing the door, in some embodiments, choke systems may be placed on the door itself. In some embodiments, the choke may be provided as part of the oven cavity or body and/or embedded in the oven cavity or body. Further, in some embodiments, the chokes or part of the choke may be incorporated into both the door and on the cavity wall facing the door (for example as illustrated in Figs. 13A and 13B). In some embodiments, one or more choke may be provided as part of the oven door and/or embedded in the oven door. In some embodiments, the choke may have at least one dimension less than $\lambda/4$, wherein A is a wavelength of the electromagnetic wave. In some embodiments, the width of the door (denoted as $W_d$ in Fig. 13B) may be 4 cm, 6 cm or less. In some embodiments, the width of the door may be in the range of the wavelength of the attenuated RF energy, for example: less than $\lambda/5$.

In the foregoing description of exemplary embodiments, various features are grouped together in embodiments for purposes of streamlining the disclosure. This method of disclosure is not to be interpreted as reflecting an intention that the claimed invention requires more features than are expressly recited in each claim. Rather, as the following claims reflect, inventive aspects may lie in less than all features of a single foregoing disclosed embodiment. Thus, the following claims are hereby incorporated into this Detailed Description, with each claim standing on its own as a separate embodiment of the invention.

Moreover, it will be apparent to those skilled in the art from consideration of the specification and practice of the present disclosure that various modifications and variations can be made to the disclosed systems and methods without departing from the scope of the invention, as claimed. For example, one or more steps of a method and/or one or more components of an apparatus or a device may be omitted, changed, or substituted without departing from the scope of the invention. Thus, it is intended that the specification and examples be considered as exemplary only, with a true scope of the present disclosure being indicated by the following claims and their equivalents.

**Claims**

1. A choke (200) configured to attenuate propagation of an electromagnetic (EM) wave between a cavity (102) and a door adjacent to an opening of the cavity, wherein the choke comprises:

two choke systems (210, 220, 910, 920) arranged in cascade, each choke system comprising a first choke component (216, 226, 915, 925) and a second choke component (218, 228) at least one of said first and second choke components having a mechanical wave attenuating structure and **characterised in that** the choke has a calculated normalized $Z_{in}$ parameter of 1 or less for at least one frequency that the choke is configured to attenuate.

2. The choke of claim 1, wherein the two choke components are sized to utilize the cyclic behavior of transmission lines' impedance.

3. The choke according to any one of the preceding claims, wherein at least one of the two choke components is a folded waveguide.

4. A choke according to any one of the preceding claims, having a calculated $S_{21}$ parameter of -45dB or less for at least one frequency that the choke is configured to attenuate.

5. A choke according to any one of the preceding claims, wherein each choke system is a resonator.

6. A choke according to any one of claims 1-4, wherein each choke system comprises a resonator.

7. A choke according to any one of the preceding claims, wherein the mechanical wave attenuating structure comprises slots oriented perpendicularly to the opening.

8. A choke according to any one of the preceding claims, wherein each of the two choke systems is configured to attenuate a propagation of a different band of frequencies having different central frequencies.

9. A door for a radiofrequency (RF) oven comprising an RF choke according to any one of claims 1-8.

10. A door according to claim 9, having a maximal width of $\lambda/5$, wherein is a wavelength of a central frequency of an attenuated band of frequencies.

11. An RF oven that includes a door comprising an RF choke according to any one of claims 1-8.

12. An RF choke according to any one of claims 1 to 8, wherein the mechanical wave attenuating structure comprises reactive elements (955) attached to the inner surface of the choke component and situated perpendicular to the propagation direction of the electromagnetic wave.

13. The choke of claim 12, wherein the conductive elements have a form of teeth.

14. A choke according to any one of claims 1 to 8, comprising a first choke component (935) and a second folded choke component (915), wherein the first choke component has a mechanical wave attenuating structure and the second folded choke component (915) has a mechanical wave attenuating structure comprising reactive elements (955) attached to the inner surface of the second folded choke component.

**Patentansprüche**

1. Drossel (200), konfiguriert zum Abschwächen der Ausbreitung einer elektromagnetischen (EM) Welle zwischen einem Hohlraum (102) und einer Tür, die zu einer Öffnung des Hohlraums benachbart ist, wobei die Drossel Folgendes aufweist:

zwei Drosselsysteme (210, 220, 910, 920), die kaskadiert angeordnet sind, wobei jedes Drosselsystem eine erste Drosselkomponente (216, 226, 915, 925) und eine zweite Drosselkomponente (218, 228) aufweist, wobei mindestens eine der ersten und der zweiten Drosselkomponente eine mechanische Struktur zum Abschwächen der Welle hat, und **dadurch gekennzeichnet, dass** die Drossel einen berechneten normalisierten Parameter $Z_{in}$ von 1 oder weniger für mindestens eine Frequenz hat, für deren Abschwächen die Drossel konfiguriert ist.

**2.** Drossel nach Anspruch 1, wobei die zwei Drosselkomponenten zum Nutzen des zyklischen Verhaltens der Impedanz von Übertragungsleitungen bemessen sind.

**3.** Drossel nach einem der vorhergehenden Ansprüche, wobei mindestens eine der zwei Drosselkomponenten ein geknickter Wellenleiter ist.

**4.** Drossel nach einem der vorhergehenden Ansprüche mit einem berechneten Parameter $S_{21}$ von -45 dB oder weniger für mindestens eine Frequenz, für deren Abschwächen die Drossel konfiguriert ist.

**5.** Drossel nach einem der vorhergehenden Ansprüche, wobei jedes Drosselsystem ein Resonator ist.

**6.** Drossel nach einem der Ansprüche 1-4, wobei jedes Drosselsystem einen Resonator aufweist.

**7.** Drossel nach einem der vorhergehenden Ansprüche, wobei die mechanische Struktur zum Abschwächen der Welle Einschnitte aufweist, die im rechten Winkel zur Öffnung ausgerichtet sind.

**8.** Drossel nach einem der vorhergehenden Ansprüche, wobei jedes der zwei Drosselsysteme dafür konfiguriert ist, eine Ausbreitung eines unterschiedlichen Frequenzbands mit unterschiedlichen mittleren Frequenzen abzuschwächen.

**9.** Tür für einen Hochfrequenz(HF)-Ofen, aufweisend eine HF-Drossel nach einem der Ansprüche 1-8.

**10.** Tür nach Anspruch 9, mit einer maximalen Breite von λ/5, wobei λ eine Wellenlänge einer mittleren Frequenz eines abgeschwächten Frequenzbands ist.

**11.** HF-Ofen, der eine Tür enthält, die eine HF-Drossel nach einem der Ansprüche 1-8 aufweist.

**12.** HF-Drossel nach einem der Ansprüche 1 bis 8, wobei die mechanische Struktur zum Abschwächen der Welle reaktive Elemente (955) aufweist, die an der Innenfläche der Drosselkomponente befestigt sind und im rechten Winkel zur Ausbreitungsrichtung der elektromagnetischen Welle angeordnet sind.

**13.** Drossel nach Anspruch 12, wobei die leitenden Elemente eine Form von Zähnen haben.

**14.** Drossel nach einem der Ansprüche 1 bis 8, aufweisend eine erste Drosselkomponente (935) und eine zweite geknickte Drosselkomponente (915), wobei die erste Drosselkomponente eine mechanische Struktur zum Abschwächen einer Welle hat und die zweite geknickte Drosselkomponente (915) eine mechanische Struktur zum Abschwächen der Welle hat, die an der Innenfläche der zweiten geknickten Drosselkomponente befestigte reaktive Elemente (955) aufweist.

**Revendications**

**1.** Piège (200) configuré pour atténuer la propagation d'une onde électromagnétique (EM) entre une cavité (102) et une porte adjacente à une ouverte de la cavité, dans lequel le piège comprend :

deux systèmes de piège (210, 220, 910, 920) agencés en cascade, chaque système de piège comprenant un premier composant de piège (216, 226, 915, 925) et un second composant de piège (218, 228), au moins l'un desdits premier et second composants de piège ayant une structure d'atténuation d'onde mécanique et étant **caractérisé en ce que** le piège présente un paramètre $Z_{in}$ normalisé calculé de 1 ou inférieur pour au moins une fréquence que le piège est configuré pour atténuer.

**2.** Piège selon la revendication 1, dans lequel les deux composants de piège sont dimensionnés pour utiliser le comportement cyclique de l'impédance de la ligne de transmission.

**3.** Piège selon une quelconque des revendications précédentes, dans lequel au moins l'un des deux composants de piège est un guide d'ondes replié.

**4.** Piège selon une quelconque des revendications précédentes, présentant un paramètre $S_{21}$ calculé de -45 dB ou inférieur pour au moins une fréquence que le piège est configuré pour atténuer.

5. Piège selon une quelconque des revendications précédentes, dans lequel chaque système de piège est un résonateur.

6. Piège selon une quelconque des revendications 1 à 4, dans lequel chaque système de piège comprend un résonateur.

7. Piège selon une quelconque des revendications précédentes, dans lequel la structure d'atténuation d'onde mécanique comprend des fentes orientées perpendiculairement à l'ouverture.

8. Piège selon une quelconque des revendications précédentes, dans lequel chacun des deux systèmes de piège est configuré pour atténuer une propagation d'une bande de fréquences différente ayant différentes fréquences centrales.

9. Porte pour un four radiofréquence (RF) comprenant un piège RF selon une quelconque des revendications 1 à 8.

10. Porte selon la revendication 9, présentant une largeur maximale de $\lambda/5$, dans laquelle $\lambda$ est une longueur d'onde d'une fréquence centrale d'une bande de fréquences atténuée.

11. Four RF qui comporte une porte comprenant un piège RF selon une quelconque des revendications 1 à 8.

12. Piège RF selon une quelconque des revendications 1 à 8, dans lequel la structure d'atténuation d'onde mécanique comprend des éléments réactifs (955) attachés à la surface intérieure du composant de piège et situés perpendiculairement à la direction de propagation de l'onde électromagnétique.

13. Piège selon la revendication 12, dans lequel les éléments conducteurs ont une forme de dents.

14. Piège selon une quelconque des revendications 1 à 8, comprenant un premier composant de piège (935) et un second composant de piège replié (915), dans lequel le premier composant de piège présente une structure d'atténuation d'onde mécanique et le second composant de piège replié (915) présente une structure d'atténuation d'onde mécanique comprenant des éléments réactifs (955) attachés à la surface intérieure du second composant de piège replié.

**FIG. 1A**

**FIG. 1B**

**FIG. 2**

**FIG. 3A**

**FIG. 3B**

**FIG. 4**

**FIG. 5**

Door

600

604          602

**FIG. 6A**

Door

610

612       612       612   612          612

**FIG. 6B**

Door

620

624

622

**FIG. 6C**

630

Door

w'

h'

634

H

632

W

**FIG. 6D**

FIG. 7A

FIG. 7B

800

Door

H₂

W₂

802

H₄

804

W₄

**FIG. 8A**

810

812

**FIG. 8B**

814

**FIG. 8C**

**FIG. 8D**

FIG. 9

**FIG. 10A**

**FIG. 10B**

1100

1110

1000

FIG. 11

FIG. 12A

FIG. 12B

FIG. 12C

FIG. 12D

FIG. 12E

FIG. 12F

FIG. 12G

FIG. 12H

FIG. 12I

FIG. 12J

FIG. 12K

FIG. 12L

FIG. 13B

FIG. 13A

**REFERENCES CITED IN THE DESCRIPTION**

**Patent documents cited in the description**

- US 61364707 A
- US 61377269 A
- EP 1744597 A
- EP 1744596 A
- JP 2003243150 A

- WO 0036878 A
- GB 2011770 A
- US 4137441 A
- US 3767884 A